# DEMANDE DE BREVET EUROPEEN

(11) **EP 1 876 641 A1**
(43) Date de publication de la demande: **09.01.2008**
(21) Numéro de dépôt: 07111746.9
(22) Date de dépôt: 04.07.2007
(51) Int. Cl.: H01L 21/687, H01J 37/32

(54) **Réacteur à plasma avec porte-substrat mécanique**

(30) Priorité: 07.07.2006 FR 0652854
(71) Demandeur: Alcatel Lucent, 75008 Paris (FR)
(72) Inventeur: Puech, Michel, 74370, Metz-Tessy (FR); Guichenal, Xavier, 74270 Chilly (FR)
(74) Mandataire: Sciaux, Edmond

(57) **Abrégé**

Dans un réacteur de gravure ou de dépôt selon l'invention, les moyens mécaniques de maintien (30) d'un substrat (2) sur un porte-substrat (3) comprennent un matériau électriquement isolant qui est localement revêtu d'un film (34) dans sa zone de contact (30a) avec le substrat (2). Le film (34) est conducteur de l'électricité. Des moyens de connexion électrique (35) permettent de le connecter sélectivement à la masse (4a). De la sorte, on évite le collage électrostatique du substrat (2) sur les moyens mécaniques de maintien (30) lors de leur retrait en position de libération pour prise du substrat (2) par un robot.

## Description

La présente invention concerne les procédés et dispositifs pour le traitement par plasma de tranches de semi-conducteurs, dans lesquels les tranches de semi-conducteurs sont soumises à des ions réactifs générés par une source de plasma pour des étapes de gravure et/ou de dépôt chimique en phase vapeur assistées par plasma.

Le traitement des tranches de semi-conducteurs, pour la fabrication de composants tels que des composants microélectroniques, des composants optoélectroniques, des microsystèmes électromécaniques microélectroniques (MEMS) ou des microsystèmes optoélectromécaniques (MOEMS), requièrent des étapes de gravure et des étapes de dépôt sur des substrats semi-conducteurs en forme de tranches ou disques plats. Ces étapes de gravure ou de dépôt sont effectuées dans un réacteur de gravure ou de dépôt, comprenant une source plasma, un porte-substrat, des moyens pour polariser le substrat et le porte-substrat, et des moyens mécaniques de maintien du substrat sur le porte-substrat. L'atmosphère intérieure du réacteur est une atmosphère gazeuse à pression réduite.

Une première fonction du porte-substrat est de soutenir le substrat pendant le procédé de gravure ou de dépôt, en laissant découverte une face active du substrat qui est soumise à l'action du flux d'ions réactifs provenant de la source de plasma. Une seconde fonction du porte-substrat est de constituer une masse conductrice de l'électricité associée au plasma et qui reçoit une polarisation radiofréquence (à 13.56 MHz) ou basse fréquence générée par les moyens de polarisation, afin d'augmenter et contrôler l'énergie relative des ions réactifs émis par la source de plasma et impactant la face active du substrat. Une troisième fonction du porte-substrat est le contrôle de la température du substrat tout au long du procédé de gravure ou de dépôt, empêchant l'emballement thermique du substrat exposé au plasma dense provenant de la source de plasma.

Pour remplir ces fonctions, le porte-substrat est une structure métallique, généralement faite d'alliage d'aluminium ou d'acier inoxydable comme les autres parties de l'enceinte du réacteur, présentant une face de support généralement plane et orientée vers la source de plasma, et sur laquelle on vient disposer le substrat selon sa face opposée à la face active elle-même soumise au plasma.

Dans le cas des porte-substrats mécaniques, le substrat est tenu plaqué contre le porte-substrat par des moyens mécaniques de maintien comprenant généralement un anneau de maintien. L'anneau de maintien vient sélectivement en appui selon une face d'appui contre la périphérie de la face active du substrat. La force d'appui est généralement de plusieurs centaines de Newton, typiquement d'environ 1 000 Newton.

Le contrôle de la température du substrat est généralement effectué en contrôlant la température du porte-substrat, par exemple par des circulations de fluides caloporteurs dans le porte-substrat, et par des résistances de chauffage installées à l'intérieur du porte-substrat. Un système de régulation assure un équilibre de température du porte-substrat. L'échange thermique entre le substrat et le porte-substrat est assuré au moyen d'un coussin d'hélium entre le porte-substrat et la face adjacente correspondante du substrat. Le coussin d'hélium est confiné par la zone périphérique du substrat qui est plaquée fermement par les moyens mécaniques de maintien contre une couronne correspondante du porte-substrat et qui assure l'étanchéité.

Pour produire une force de maintien satisfaisante, on a le plus souvent utilisé un anneau de maintien en métal, de préférence en aluminium.

Une telle structure connue présente toutefois plusieurs inconvénients. Un premier inconvénient réside dans les phénomènes de gravure parasites qui se produisent sur la surface de l'anneau de maintien. En effet, en appliquant la polarisation RF ou BF au porte-substrat, on polarise nécessairement l'anneau métallique de maintien, ce qui augmente l'énergie relative des ions venant frapper l'anneau métallique de maintien. Il en résulte, pendant les étapes de gravure du substrat, une gravure simultanée de l'anneau de maintien, qui réduit rapidement sa résistance mécanique et sa capacité à assurer le maintien du substrat. Il faut alors remplacer périodiquement l'anneau de maintien, ce qui nécessite des interventions fréquentes des opérateurs, des interruptions de fonctionnement, et ce qui augmente le coût d'utilisation du réacteur.

Un autre problème résulte du fait que le bombardement de l'anneau de maintien par les ions provenant du plasma provoque une élévation de la température de l'anneau de maintien. Ainsi, on peut observer une élévation significative de la température quelques minutes après le début d'un procédé de gravure. La chaleur générée dans l'anneau de maintien se propage vers la surface périphérique de contact du substrat, causant une distribution non homogène de la température dans le substrat. Ainsi, puisque les mécanismes de gravure sont très sensibles à la température du substrat, la gravure résultante n'est pas homogène sur tout le substrat, et ne présente pas les qualités recherchées de profondeur et d'anisotropie.

Un autre problème résulte du fait que le bombardement de l'anneau de maintien par les ions provenant du plasma provoque une contamination métallique de surface du substrat.

Pour réduire les effets néfastes du bombardement ionique sur l'anneau de maintien, on a proposé une solution consistant à passiver l'anneau de maintien en utilisant un procédé spécifique de dépôt afin de recouvrir d'une couche mince d'alumine la surface supérieure de l'anneau de maintien, ou surface soumise au flux d'ions réactifs provenant de la source de plasma. Cette couche mince d'alumine est chimiquement inerte et électriquement isolante. Cependant, cette couche mince est rapidement dégradée par le flux d'ions réactifs provenant de la source de plasma, et la protection qui en résulte est de courte durée.

Une autre solution connue consiste à utiliser un anneau de maintien entièrement en matériau diélectrique, par exemple en céramique de type oxyde d'aluminium. Un tel matériau diélectrique permet de polariser le substrat en évitant de polariser simultanément l'anneau de maintien lui-même. Il en résulte une réduction du flux d'ions réactifs parvenant sur l'anneau de maintien lui-même, ce qui réduit la gravure de l'anneau de maintien et ce qui réduit son élévation de température. Une autre solution, décrite dans le document EP 1 263 025, propose un réacteur où l'anneau de maintien est protégé par un bouclier interchangeable interposé entre l'anneau de maintien et la source de plasma. Le bouclier interchangeable peut être composé d'un simple anneau métallique connecté électriquement à la masse, empêchant l'anneau de maintien de subir l'érosion mécanique due au flux d'ions réactifs du plasma, et agissant en même temps en tant que bouclier thermique pour éviter l'élévation de température de l'anneau de maintien.

Dans tous les réacteurs à maintien mécanique des substrats, lorsque le procédé de gravure ou de dépôt est terminé, on doit retirer le substrat hors du réacteur pour introduire un nouveau substrat à traiter. L'opération de retrait du substrat comprend une première étape au cours de laquelle on écarte le dispositif mécanique de maintien à l'écart du porte-substrat, pour permettre à un robot de prendre le substrat et de le déplacer tout d'abord axialement à l'écart du porte-substrat puis latéralement vers l'extérieur du réacteur.

Jusqu'à présent, les substrats semi-conducteurs ont été sous forme de tranches ou de disques ayant une épaisseur d'environ 500 à 800 microns, pour un diamètre de 100 à 300 mm. Les opérations de libération par retrait des moyens de maintien se passent relativement bien.

Cependant, dans un souci permanent d'augmenter encore l'intégration des systèmes microélectroniques, on s'oriente depuis quelques temps vers le traitement de substrats d'épaisseur réduite, ces substrats ayant des épaisseurs pouvant être de l'ordre de 100 microns par exemple.

On constate alors, dans les réacteurs connus, une augmentation des défauts de manipulation des substrats par les robots en sortie des réacteurs de gravure ou de dépôt. Il se produit fréquemment un échec de prise du substrat par le robot, dans les réacteurs de gravure ou de dépôt par ions réactifs dans lesquels les moyens de maintien mécanique de substrat comportent un matériau électriquement isolant qui s'oppose à la polarisation des moyens mécaniques de maintien par contact avec le substrat.

La présente invention résulte de l'observation minutieuse de ces défauts de manipulation et de leurs causes possibles.

Il apparaît que les erreurs de manipulation résultent d'un phénomène de collage des substrats contre le dispositif mécanique de maintien lors de l'étape au cours de laquelle on déplace le dispositif de maintien à l'écart du porte-substrat pour libérer le substrat et permettre sa manipulation par un robot.

Ainsi, le problème proposé par la présente invention est d'éviter les défauts de manipulation des substrats en sortie des réacteurs de gravure ou de dépôt par ions réactifs dans lesquels les moyens de maintien mécanique de substrat comportent un matériau électriquement isolant qui s'oppose à la polarisation des moyens mécaniques de maintien par contact avec le substrat.

En pratique, l'invention vise à évacuer les charges électriques accumulées pendant le procédé de traitement du substrat sur le substrat ou sur le moyen mécanique de maintien du substrat, ces charges pouvant être responsables d'un collage électrostatique du substrat contre les moyens mécaniques de maintien du substrat, collage électrostatique suffisamment fort pour vaincre le poids du substrat et provoquer son entraînement par les moyens mécaniques de maintien lors de leur retrait à l'écart du porte-substrat.

Un autre objet de l'invention est de résoudre le problème ci-dessus par une modification particulièrement simple du réacteur de gravure ou de dépôt.

Pour atteindre ces buts ainsi que d'autres, l'invention propose un réacteur de gravure d'un substrat ou de dépôt sur un substrat, comprenant une source plasma, un porte-substrat, des moyens pour polariser le substrat et le porte-substrat, et des moyens mécaniques de maintien adaptés pour plaquer le substrat contre le porte-substrat en venant sélectivement en appui selon une face d'appui contre la périphérie de la face active du substrat, les moyens mécaniques de maintien comprenant un matériau électriquement isolant qui s'oppose à la polarisation des moyens mécaniques de maintien par contact avec le substrat, dans lequel :
- le matériau électriquement isolant est localement revêtu d'un film dans sa zone de contact avec le substrat,
- le film est conducteur de l'électricité,
- des moyens de connexion électrique permettent de connecter sélectivement à la masse le film conducteur de l'électricité.

La connexion électrique, qui connecte à la masse le film conducteur de l'électricité, permet d'évacuer les charges électriques accumulées durant le procédé de gravure ou de dépôt sur la portion périphérique de face active du substrat et sur la face correspondante des moyens mécaniques de maintien, empêchant ainsi que ces charges électriques accumulées produisent un effet de collage électrostatique entre le substrat et les moyens mécaniques de maintien. De la sorte, après l'étape de traitement du substrat, lorsque l'on écarte les moyens mécaniques de maintien à l'écart du porte-substrat pour libérer le substrat, ce dernier reste posé sur le porte-substrat sans déplacement, et se trouve directement accessible par un robot de manipulation.

En pratique, le film conducteur de l'électricité peut être un film métallique. Un tel film métallique peut être aisément réalisé par dépôt chimique en phase vapeur assisté par plasma sur le matériau électriquement isolant des moyens mécanique de maintien. La réalisation est ainsi particulièrement simple.

De préférence, le film conducteur de l'électricité est réalisé en aluminium. L'aluminium est bon conducteur de l'électricité, et facile à déposer en couches minces. En outre, l'aluminium est très utilisé dans le domaine des MEMS et des semi-conducteurs.

Selon un premier mode de réalisation, le matériau électriquement isolant peut former un corps isolant de moyens mécaniques de maintien. On réalise ainsi une structure simple, constituée d'un bloc entier isolant.

En alternative, les moyens mécaniques de maintien peuvent comporter un corps métallique qui peut être connecté électriquement à la masse et qui est revêtu d'une couche dudit matériau électriquement isolant selon sa face d'appui contre le substrat. Le corps métallique, lorsqu'il est connecté à la masse, constitue un bouclier qui dévie le plasma et qui réduit encore les effets du flux d'ions réactifs sur les moyens mécaniques de maintien.

De préférence, les moyens de connexion électrique du film conducteur de l'électricité connectent le film conducteur de l'électricité au porte-substrat. Un premier avantage est que cette connexion électrique est simple et courte. Un second avantage est que cela améliore la polarisation du substrat pendant les étapes de traitement, en réalisant avec le porte-substrat une structure conductrice de l'électricité qui enveloppe en grande partie le substrat.

De préférence, le réacteur comprend des moyens de connexion de porte-substrat pour connecter sélectivement le porte-substrat à la masse, pendant les étapes de transfert de substrat, c'est-à-dire en dehors des étapes de traitement du substrat au cours desquelles le porte-substrat est polarisé. On réalise de cette façon des connexions électriques simples, sans ajout de connecteurs supplémentaires.

En pratique, on peut avantageusement prévoir des moyens de connexion électrique qui sont mécaniquement solidaires du porte-substrat et qui sont adaptés pour venir en appui élastique sur le film conducteur de l'électricité lorsque lesdits moyens mécaniques de maintien sont en appui sur la périphérie de la face active du substrat. De la sorte, les moyens de connexion électrique sont en permanence disponibles, étant solidaires du porte-substrat, et l'appui élastique réalise un amorti mécanique et le caractère réversible de la connexion.

Dans ce cas, les moyens de connexion électrique peuvent en pratique dépasser au-delà de la surface du porte-substrat lorsque les moyens mécaniques de maintien sont à l'écart de la face active du substrat, et les moyens de connexion électrique sont repoussés par les moyens mécaniques de maintien vers le porte-substrat lorsque le film conducteur de l'électricité vient en appui sur la périphérie de la face active du substrat. On assure ainsi à la fois et de façon réversible un contact mécanique et une connexion électrique de façon automatique par simple mouvement des moyens mécaniques de maintien vers ou à l'écart du porte-substrat.

De préférence, on structure les moyens de connexion électrique de façon à assurer simultanément la conduction d'électricité et la conduction de l'énergie calorifique entre le porte-substrat et les moyens mécaniques de maintien. Cela permet de contrôler simultanément la température des moyens mécaniques de maintien, évitant d'une part la détérioration des moyens mécaniques de maintien par surchauffe, et évitant d'autre part d'induire un gradient de température entre la zone périphérique du substrat et la zone centrale du substrat, gradient de température susceptible d'affecter le caractère anisotrope du traitement réalisé par les ions réactifs sur le substrat.

En pratique, les moyens mécaniques de maintien peuvent comprendre un anneau de maintien, qui assure une meilleure répartition de la force mécanique exercée par les moyens mécaniques de maintien sur le substrat.

D'autres objets, caractéristiques et avantages de la présente invention ressortiront de la description suivante de modes de réalisation particuliers, faite en relation avec les figures jointes, parmi lesquelles :
- la figure 1 est une représentation schématique globale d'un réacteur à source plasma pour la gravure d'un substrat ou le dépôt sur un substrat, selon un mode de réalisation de l'invention ;
- la figure 2 est une vue schématique agrandie illustrant, en position de serrage et en position de libération, un porte-substrat et des moyens mécaniques de maintien selon un mode de réalisation de la présente invention ;
- la figure 3 est une vue schématique similaire de la figure 2, pour un second mode de réalisation des moyens mécaniques de maintien selon la présente invention ; et
- la figure 4 est une vue schématique partielle illustrant la circulation des charges électriques dans une structure selon la figure 3.

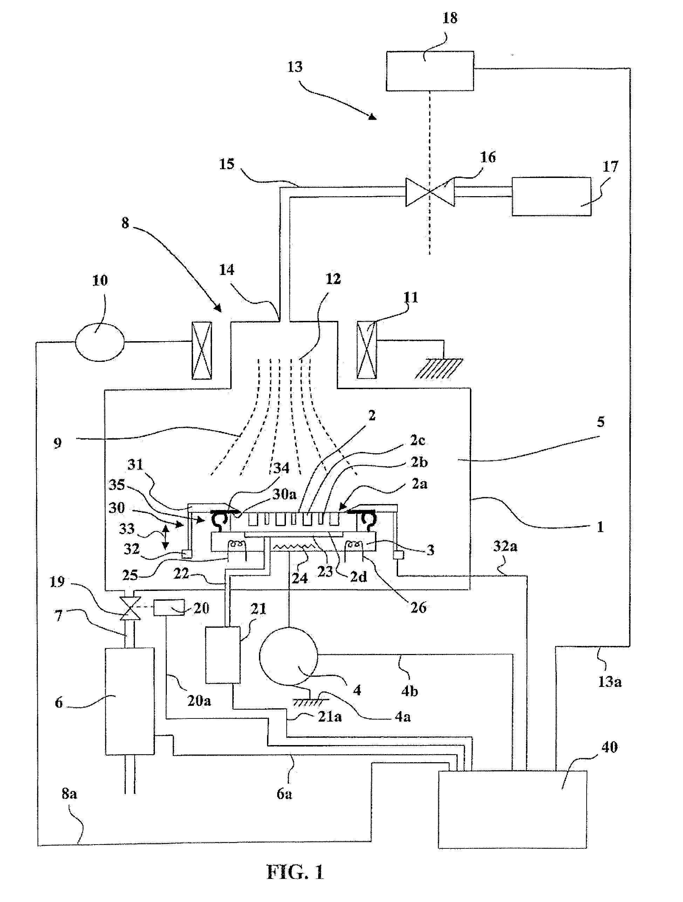

On considère tout d'abord la figure 1, dans laquelle sont illustrés les principaux éléments d'un réacteur selon la présente invention.

Un tel réacteur comprend, de façon connue, une chambre de procédé ayant une enceinte 1 étanche, conformée pour recevoir et contenir un substrat 2 à traiter. Le substrat 2 est posé sur un support de substrat 3 lui-même conducteur de l'électricité et connecté électriquement à une source de polarisation 4.

L'atmosphère intérieure 5 de l'enceinte 1 est une atmosphère gazeuse à pression réduite, contrôlée par un dispositif de génération de vide 6 relié à l'enceinte 1 par une canalisation 7. Le dispositif de génération de vide 6 comprend par exemple une pompe primaire et une pompe secondaire, pour créer et maintenir un vide approprié dans l'atmosphère intérieure 5 de l'enceinte 1.

Le substrat 2 est orienté dans l'enceinte 1 de façon que sa face active 2a à traiter soit apparente. On veut par exemple réaliser sur la surface active 2a des cavités telles que les cavités 2b et 2c.

En regard de la face active 2a à traiter, se trouve une source de plasma 8, pour générer un plasma 9 qui, du fait de la polarisation du porte-substrat 3 et du substrat 2, est dirigée vers la face active 2a à traiter.

La source de plasma 8 comprend, de façon schématique, un générateur de micro-ondes ou radiofréquences 10 qui, par l'intermédiaire d'un transducteur ou d'un applicateur radiofréquence 11, excite les atomes de gaz dans une zone de génération de plasma 12 de l'enceinte 1.

Le réacteur comprend en outre des moyens 13 pour injecter sélectivement dans l'enceinte 1 des gaz appropriés en fonction de l'étape de procédé en cours, par exemple des gaz de gravure ou des gaz de passivation. Ces moyens d'injection de gaz 13 comprennent une entrée de gaz 14 dans l'enceinte 1, de préférence en amont de la zone de génération de plasma 12. L'entrée de gaz 14 est reliée par des canalisations 15 et des vannes de commande 16 à des sources de gaz 17. Les vannes de commande 16 sont actionnées par des moyens d'actionnement 18 pour piloter l'injection des gaz selon les étapes successives de traitement du substrat.

Une vanne réglable 19 est prévue dans la canalisation 7 qui relie le dispositif de génération de vide 6 à l'enceinte 1, pour contrôler la pression dans l'enceinte 1. La vanne 19 est pilotée par un actionneur 20.

Le réacteur comprend également des moyens de contrôle de la température du substrat 2. Dans la réalisation illustrée sur la figure 1, ces moyens de contrôle de température du substrat 2 comprennent une source d'hélium 21 raccordée par une canalisation 22 à un diffuseur 23 prévu dans le support de substrat 3 pour diffuser de l'hélium contre la face d'appui 2d du substrat 2 qui est opposée à sa face active 2a. On utilise ainsi les propriétés de l'hélium en tant que conducteur thermique, pour relier thermiquement le substrat 2 au porte-substrat 3.

Pour parfaire le contrôle thermique, on prévoit dans le porte-substrat 3 des moyens de régulation thermique, par exemple des résistances électriques telles que la résistance électrique 24, et des moyens de circulation de fluide caloporteur tels que les canaux 25 et 26, ces moyens étant répartis de manière appropriée dans le porte-substrat 3 pour garantir une température uniforme du substrat 2.

Le fluide caloporteur traversant les canaux 25 et 26 peut être de l'azote liquide, pour le refroidissement du substrat 2.

La source de polarisation 4 est adaptée pour polariser négativement le porte-substrat 3 pendant les étapes de traitement du substrat 2 par le plasma 9, avec une composante radiofréquence (RF) ou basse fréquence (BF), afin de favoriser l'impact des ions réactifs du plasma 9 sur la face active 2a du substrat 2.

En dehors des étapes de traitement de la face active 2a du substrat 2, la source de polarisation 4 connecte le porte-substrat 3 à la masse 4a, pour évacuer les charges éventuellement accumulées sur le porte-substrat 3 pendant le traitement.

Le réacteur selon l'invention comprend en outre, de façon connue, des moyens mécaniques de maintien 30, adaptés pour plaquer le substrat 2 contre le porte-substrat 3 en venant sélectivement en appui selon une face d'appui 30a contre la périphérie de la face active 2a du substrat 2.

Les moyens mécaniques de maintien 30 comprennent un matériau électriquement isolant qui s'oppose à la polarisation des moyens mécaniques de maintien 30 par contact avec le substrat 2, pendant les étapes de traitement par le plasma 9. Le matériau électriquement isolant est choisi de telle façon que sa tangente de perte diélectrique soit la plus proche possible de zéro. En pratique, on choisira un matériau dont la tangente de perte diélectrique est inférieure à 10⁻³, de préférence inférieure à 5.10⁻⁴. Cela permet simultanément de limiter les pertes par absorption du champ électrique HF ou BF dû à la polarisation du porte-substrat 3. Un tel matériau isolant peut être choisi parmi les matières plastiques ou les céramiques isolantes, par exemple le PTFE, l'oxyde d'aluminium, l'oxyde d'yttrium, le nitrure d'aluminium.

Dans la réalisation illustrée sur les figures, les moyens mécaniques de maintien 30 ont la forme d'un anneau de maintien 31, en appui selon le pourtour de la face active 2a du substrat 2.

Les moyens mécaniques de maintien 30 tels que l'anneau de maintien 31 sont sollicités mécaniquement en translation par des moyens d'entraînement tels que des vérins 32 pour être déplacés sélectivement vers et à l'écart du porte-substrat 3 selon une direction axiale comme illustré par les doubles flèches 33. Les moyens mécaniques de maintien 30 peuvent ainsi prendre une position de serrage telle qu'illustrée sur la figure 1, plaquant le substrat 2 contre le porte-substrat 3, et une position de libération dans laquelle ils sont relevés à l'écart du porte-substrat 3 pour permettre l'introduction ou le retrait d'un substrat 2 sur le porte-substrat 3.

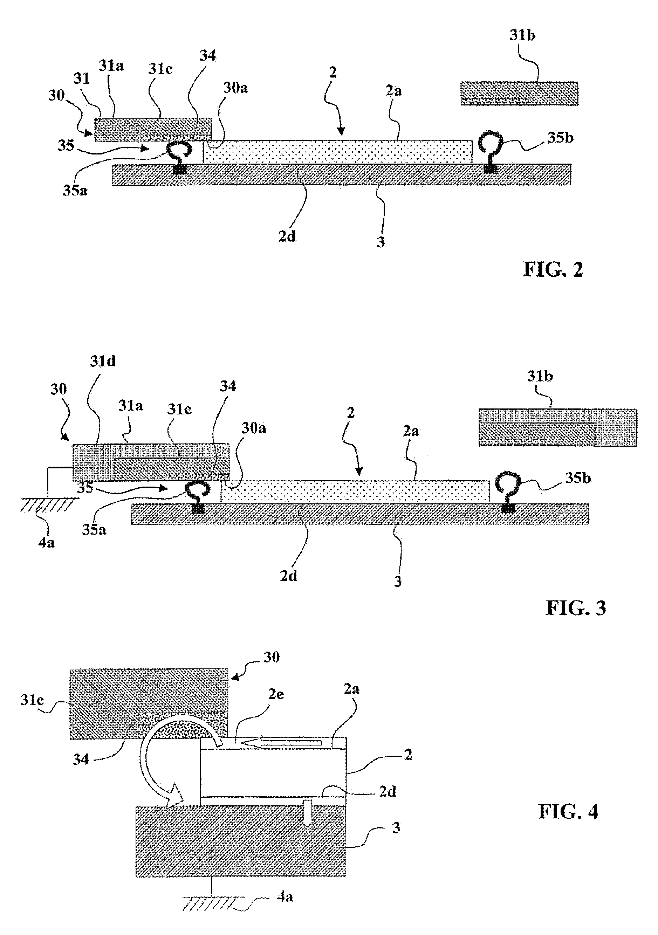

On considère maintenant les figures 2 à 4, qui illustrent à plus grande échelle les moyens spécifiques de l'invention permettant d'éviter les phénomènes de collage électrostatique du substrat 2 sous les moyens mécaniques de maintien 30 lors du relèvement des moyens mécaniques de maintien 30 à l'écart du porte-substrat 3 en fin de traitement du substrat 2.

On retrouve, sur les figures 2 et 3, le substrat 2 posé sur le porte-substrat 3, schématiquement représenté sans ses moyens de régulation thermique. On retrouve également les moyens mécaniques de maintien 30, sous forme d'un anneau de maintien 31 qui est ici illustré dans ses deux positions extrêmes, à savoir en partie gauche des figures la position de maintien 31a dans laquelle la face d'appui 30a est appliquée sur la périphérie de la face active 2a du substrat 2, et en partie droite des figures la position de libération 31b dans laquelle les moyens mécaniques de maintien sont à l'écart du porte-substrat 3 et la face d'appui est donc à l'écart du substrat 2, permettant la préhension du substrat 2 par un robot (non représenté).

Les moyens mécaniques de maintien 30 comprennent le matériau électriquement isolant 31c.

Dans le mode de réalisation illustré sur la figure 2, le matériau électriquement isolant 31c forme un corps isolant, c'est-à-dire que le matériau électriquement isolant 31c constitue la quasi-totalité des moyens mécaniques de maintien 30. On choisit alors le matériau électriquement isolant 31c pour présenter à la fois des qualités d'isolation électrique et également des qualités de résistance mécanique pour assurer une force d'appui suffisante du substrat 2 sur le porte-substrat 3 lors des étapes de traitement.

Dans le second mode de réalisation illustré sur la figure 3, le matériau électriquement isolant 39c est sous forme d'une couche dudit matériau électriquement isolant. Dans ce cas, les moyens mécaniques de maintien 30 comportent un corps métallique 31d, revêtu de ladite une couche dudit matériau électriquement isolant 31 c selon sa face d'appui contre le substrat 2.

Le corps métallique 31d peut, selon les étapes de procédé, être couplé soit au potentiel de polarisation du porte-substrat 3, soit à un potentiel flottant, soit à la masse 4a.

Selon l'invention, le matériau électriquement isolant 31c, dans l'un et l'autre des modes de réalisation des figures 2 et 3, est localement revêtu d'un film 34 dans sa zone de contact avec le substrat 2. Le film 34 est conducteur de l'électricité, par exemple réalisé en métal, avantageusement réalisé en aluminium.

Le film 34 conducteur de l'électricité couvre en grande partie, de préférence en totalité, la zone de contact 30a du matériau électriquement isolant 31 c avec le substrat 2, et se prolonge radialement vers l'extérieur au-delà du substrat 2.

Le métal constituant le film 34 conducteur de l'électricité est choisi de façon à être compatible avec la technologie du vide, pour éviter la contamination dans les procédés des équipements de gravure profonde.

Le film 34 conducteur de l'électricité doit pouvoir tenir des tensions de l'ordre de 5 kV et supporter des températures de plus de 150°C. En outre, étant en contact direct avec le substrat 2, le film 34 conducteur de l'électricité doit encaisser la pression de maintien du substrat 2, sans se dégrader, et tout en préservant l'intégralité du substrat 2. Cette force de maintien est de l'ordre de 1 000 N, ce qui représente une pression d'environ 480 N/cm² pour un diamètre de substrat 2 d'environ 100 mm.

L'épaisseur du film 34 électriquement conducteur peut être d'environ 0.5 mm. Ce film peut être déposé avec une technologie torche plasma, qui a l'avantage de pouvoir déposer des couches relativement épaisses de métal sur quasiment tous les matériaux céramiques. Cependant, l'adhésion de la couche de métal sur la céramique impose des traitements spécifiques de celle-ci, traitements qui font partie de l'état de la technique connu. On sait aussi que ces traitements ne sont pas toujours compatibles avec les matériaux compatibles semi-conducteurs. On choisira donc la céramique et le métal en fonction de la compatibilité recherchée.

Des moyens de connexion électrique 35 permettent de connecter sélectivement à la masse 4a ledit film 34 conducteur de l'électricité. L'expression "permettent de connecter sélectivement à la masse" signifie que les moyens de connexion électrique 35 permettent de connecter à la masse 4a le film 34 conducteur de l'électricité au moins juste avant l'étape de libération du substrat 2 par retrait des moyens mécaniques de maintien 30 jusqu'à leur position de libération 31b, la connexion électrique à la masse 4a étant interrompue pendant les étapes de traitement de la face active 2a du substrat 2 par le plasma.

Dans le mode de réalisation avantageux illustré sur les figures, les moyens de connexion électrique 35 sont connectés électriquement au porte-substrat 3. En pratique, les moyens de connexion électrique 35 sont mécaniquement solidaires du porte-substrat 3 et comprennent des lames élastiquement flexibles telles que les lames 35a et 35b adaptées pour venir en appui élastique sur le film 34 conducteur de l'électricité lorsque lesdits moyens mécaniques de maintien 30 sont en appui sur la périphérie de la face active 2a du substrat 2, comme illustré sur la partie gauche des figures 2 et 3.

Les moyens de connexion électrique 35 peuvent être réalisés à l'aide de bandes de contact de marque PHYTRONIC. vissées dans le porte-substrat 3.

Lorsque les moyens mécaniques de maintien 30 sont à l'écart de la face active 2a du substrat 2, les moyens de connexion électrique 35 tels que les lames 35a et 35b sont au repos et dépassent au-delà de la surface du porte-substrat 3, selon une hauteur supérieure à l'épaisseur des substrats 2 à traiter, comme on le voit sur les parties droites des figures 2 et 3. De la sorte, lorsque les moyens mécaniques de maintien 30 reviennent en position de maintien, ils repoussent les moyens de connexion électrique 35 vers le porte-substrat 3, et le film 34 conducteur de l'électricité vient en appui à la fois sur la périphérie de la face active 2a du substrat 2 et sur les moyens de connexion électrique 35, assurant la connexion électrique entre le film 34 conducteur de l'électricité et le porte-substrat 3.

La structure élastique des moyens de connexion électrique 35 assure la connexion de la surface du substrat 2 à la masse 4a quelle que soit l'épaisseur du substrat 2, c'est-à-dire quelle que soit la distance entre la face du support du porte-substrat 3 et la face d'appui 30a correspondante des moyens mécaniques de maintien 30.

Simultanément, des moyens de connexion de porte-substrat, constitués par la source de polarisation 4 (figure 1), permettent de connecter sélectivement le porte-substrat 3 à la masse 4a.

Les lames élastiquement flexibles 35a et 35b seront constituées en métal bon conducteur de l'électricité et également bon conducteur de la chaleur. On fera en sorte d'assurer un contact large entre les lames 35a et 35b et le film 34 conducteur de l'électricité, avec une section transversale suffisante des lames élastiques 35a et 35b, de façon à favoriser, simultanément à la conduction de l'électricité, une conduction significative de l'énergie calorifique entre le porte-substrat 3 et les moyens mécaniques de maintien 30. La régulation thermique du porte-substrat 3 permet ainsi de réguler thermiquement non seulement le substrat 2 mais également les moyens mécaniques de maintien 30.

La figure 4 illustre l'effet du film 34 conducteur de l'électricité, permettant d'éviter le collage électrostatique du substrat 2 sur les moyens mécaniques de maintien 30 lors de la libération du substrat 2. Pendant le traitement de la surface active 2a du substrat 2 par les ions réactifs du plasma, des charges électriques 2e peuvent apparaître sur le substrat 2. Ces charges électriques 2e s'évacuent par le film 34 conducteur de l'électricité lui-même connecté au porte-substrat métallique 3 qui lui-même est connecté à la masse 4a. En supprimant ces charges électriques 2e, on évite simultanément tout risque de collage électrostatique du substrat 2 sur le matériau électriquement isolant 31 c des moyens mécaniques de maintien 30.

On considère à nouveau la figure 1, sur laquelle on retrouve les moyens de connexion électrique 35 et le film 34 conducteur de l'électricité. La source de polarisation 4 est adaptée pour sélectivement polariser le porte-substrat 3 pendant les étapes de traitement du substrat 2 par le plasma 9, et pour sélectivement connecter le porte-substrat 3 à la masse 4a en dehors des étapes de traitement du substrat 2.

En pratique, des moyens de commande 40, tels qu'un processeur associé à des mémoires et à un programme enregistré dans les mémoires, pilotent les différents organes du réacteur de façon à réaliser les étapes successives de fonctionnement.

Pour cela, les moyens de commande 40 pilotent par une ligne 13a les moyens d'injection de gaz 13, par une ligne 8a la source de plasma 8, par une ligne 6a le dispositif de génération de vide 6, par une ligne 20a l'actionneur 20 de la vanne 19, par une ligne 21a la source d'hélium 21, par une ligne 4b la source de polarisation 4, et par une ligne 32a les vérins 32 de déplacement des moyens mécaniques de maintien 30. Le fonctionnement est exposé succinctement ci-après.

Les moyens mécaniques de maintien 30 sont initialement en position de libération.

Un substrat 2 est introduit dans l'enceinte 1 par un robot (non représenté) à travers une porte (non représentée), et est posé sur le porte-substrat 3. Le robot se retire et la porte se referme. Les moyens mécaniques de maintien 30 viennent en appui sur le pourtour supérieur de la face active 2a du substrat 2, pour plaquer fermement le substrat 2 sur le porte-substrat 3, assurant l'étanchéité périphérique du volume intérieur du diffuseur 23 d'hélium. Le dispositif de génération de vide 6 établit un vide contrôlé dans l'atmosphère intérieure 5, en présence de gaz pilotés par les moyens d'injection de gaz 13, en pression réduite. On génère ensuite un plasma 9 par la source de plasma 8, en on régule la température du porte-substrat 3 et du moyen mécanique de maintien 30, pour réaliser des traitements tels que des gravures 2b et 2c sur la face active 2a du substrat 2. Lorsque les traitements sont terminés, on ramène les moyens mécaniques de maintien 30 en position de libération, et le robot peut à nouveau prendre le substrat 2 pour le retirer hors du réacteur.

La présente invention n'est pas limitée aux modes de réalisation qui ont été explicitement décrits, mais elle en inclut les diverses variantes et généralisations qui sont à la portée de l'homme du métier.

## Revendications

1. - Réacteur de gravure d'un substrat (2) ou de dépôt sur un substrat (2), comprenant une source plasma (8), un porte-substrat (3), des moyens (4) pour polariser le substrat (2) et le porte-substrat (3), et des moyens mécaniques de maintien (30) adaptés pour plaquer le substrat (2) contre le porte-substrat (3) en venant sélectivement en appui selon une face d'appui (30a) contre la périphérie de la face active (2a) du substrat (2), les moyens mécaniques de maintien (30) comprenant un matériau électriquement isolant (31c) qui s'oppose à la polarisation des moyens mécaniques de maintien (30) par contact avec le substrat (2),
**caractérisé en ce que** :
- le matériau électriquement isolant (31c) est localement revêtu d'un film (34) dans sa zone de contact avec le substrat (2),
- le film (34) est conducteur de l'électricité,
- des moyens de connexion électrique (35) permettent de connecter sélectivement à la masse (4a) le film (34) conducteur de l'électricité.

2. - Réacteur selon la revendication 1, **caractérisé en ce que** ledit film (34) conducteur de l'électricité est métallique.

3. - Réacteur selon la revendication 2, **caractérisé en ce que** le film (34) conducteur de l'électricité est en aluminium.

4. - Réacteur selon l'une quelconque des revendications 1 à 3, **caractérisé en ce que** le matériau électriquement isolant (31 c) forme un corps isolant de moyens mécaniques de maintien.

5. - Réacteur selon l'une quelconque des revendications 1 à 4, **caractérisé en ce que** les moyens mécaniques de maintien (30) comportent un corps métallique (31d) qui peut être connecté électriquement à la masse (4a) et qui est revêtu d'une couche dudit matériau électriquement isolant (31 c) selon sa face d'appui (30a) contre le substrat (2).

6. - Réacteur selon l'une quelconque des revendications 1 à 5, **caractérisé en ce que** lesdits moyens de connexion électrique (35) sont connectés électriquement au porte-substrat (3).

7. - Réacteur selon l'une quelconque des revendications 1 à 6, **caractérisé en ce qu'**il comprend des moyens de connexion de porte-substrat (4) pour connecter sélectivement ledit porte-substrat (3) à la masse (4a).

8. - Réacteur selon l'une quelconque des revendications 1 à 7, **caractérisé en ce que** lesdits moyens de connexion électrique (35) sont mécaniquement solidaires du porte-substrat (3) et sont adaptés pour venir en appui élastique sur le film (34) conducteur de l'électricité lorsque lesdits moyens mécaniques de maintien (30) sont en appui sur la périphérie de la face active (2a) du substrat (2).

9. - Réacteur selon la revendication 8, **caractérisé en ce que** lesdits moyens de connexion électrique (35) dépassent au-delà de la surface du porte-substrat (3) lorsque les moyens mécaniques de maintien (30) sont à l'écart de la face active (2a) du substrat (2), et lesdits moyens de connexion électrique (35) sont repoussés par les moyens mécaniques de maintien (30) vers le porte-substrat (3) lorsque le film (34) conducteur de l'électricité vient en appui sur la périphérie de la face active (2a) du substrat (2).

10. - Réacteur selon l'une des revendications 8 ou 9, **caractérisé en ce que** lesdits moyens de connexion électrique (35) sont conformés pour assurer, simultanément à la conduction d'électricité, une conduction de l'énergie calorifique entre le porte-substrat (3) et les moyens mécaniques de maintien (30).

11. - Réacteur selon l'une quelconque des revendications 1 à 10, **caractérisé en ce que** lesdits moyens mécaniques de maintien (30) comprennent un anneau de maintien (31).
